(19) Europäisches Patentamt
European Patent Office
Office européen des brevets

(11) **EP 2 795 348 B1**

(12) **FASCICULE DE BREVET EUROPEEN**

(45) Date de publication et mention
de la délivrance du brevet:
**10.05.2017 Bulletin 2017/19**

(21) Numéro de dépôt: **12810367.8**

(22) Date de dépôt: **07.12.2012**

(51) Int Cl.:
*G01R 19/25* (2006.01)     *G06F 11/30* (2006.01)
*G06Q 50/06* (2012.01)     *G01R 21/06* (2006.01)
*G01R 21/133* (2006.01)

(86) Numéro de dépôt international:
**PCT/FR2012/052829**

(87) Numéro de publication internationale:
**WO 2013/093280 (27.06.2013 Gazette 2013/26)**

(54) **PROCEDE DE DETERMINATION D'UNE CONSOMMATION DE PUISSANCE DANS UNE INSTALLATION ELECTRIQUE ET INSTALLATION ELECTRIQUE À COURANT ALTERNATIF**

VERFAHREN ZUM BESTIMMEN DES LEISTUNGSVERBRAUCHS IN EINER ELEKTRISCHEN ANLAGE UND WECHSELSTROMANLAGE

METHOD FOR DETERMINING POWER CONSUMPTION IN AN ELECTRICAL INSTALLATION, AND ALTERNATING-CURRENT ELECTRICAL INSTALLATION

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **20.12.2011 FR 1103955**

(43) Date de publication de la demande:
**29.10.2014 Bulletin 2014/44**

(73) Titulaire: **Schneider Electric Industries SAS
92500 Rueil-Malmaison (FR)**

(72) Inventeur: **BRUEL, Marc
F-38050 Cedex 09 Grenoble (FR)**

(74) Mandataire: **Tripodi, Paul
Schneider Electric Industries SAS
Service Propriété Industrielle
World Trade Center / 38EE1
5 Place Robert Schuman
38050 Grenoble Cedex 09 (FR)**

(56) Documents cités:
**EP-A1- 2 026 299       EP-A1- 2 241 898
EP-A2- 0 853 364       WO-A1-2009/158202
WO-A1-2011/002735    US-A- 5 696 695
US-A1- 2008 140 326    US-A1- 2009 088 990**

• **CHUNG-PING YOUNG ET AL: "Digital Power Metering Manifold", IEEE TRANSACTIONS ON INSTRUMENTATION AND MEASUREMENT, IEEE SERVICE CENTER, PISCATAWAY, NJ, US, vol. 47, no. 1, 1 février 1998 (1998-02-01), XP011024460, ISSN: 0018-9456**

**Description**

**Domaine technique de l'invention**

L'invention concerne un procédé de détermination d'une consommation de puissance dans une installation électrique, dans laquelle un groupe de plusieurs branches de distribution individuelle connectées en parallèle est raccordé à une alimentation en courant alternatif. Le procédé en question est du type comprenant l'action d'effectuer dans le temps et d'enregistrer des mesures de la tension globale d'alimentation du groupe de plusieurs branches, ainsi que des mesures des valeurs d'intensité et de déphasage du courant global d'alimentation de ce groupe.

L'invention concerne également une installation électrique en courant alternatif, du type comportant un groupe de plusieurs branches de distribution individuelle connectées en parallèle, ainsi qu'un système de supervision adapté pour effectuer dans le temps et enregistrer des mesures d'une tension globale d'alimentation du groupe de plusieurs branches, ainsi que des mesures des valeurs d'intensité et de déphasage d'un courant global d'alimentation de ce groupe.

**État de la technique**

Les particuliers comme les autres agents économiques montrent un intérêt croissant pour la maîtrise de leurs propres consommations électriques. Un axe de cette maîtrise repose sur une connaissance détaillée de différentes consommations particulières à l'intérieur d'une consommation globale. Par exemple, les habitants d'une maison ou d'un logement d'un autre type peuvent s'intéresser à leur consommation électrique due au chauffage, à celle consacrée à l'éclairage et/ou celle due à tel équipement, sans se satisfaire de la seule connaissance de la consommation globale à l'échelle du logement.

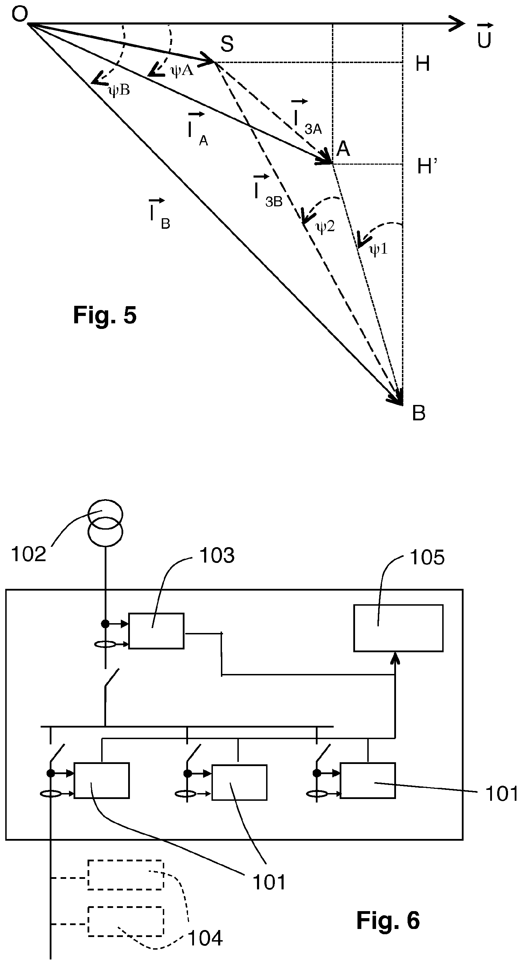

A l'heure actuelle, les habitants d'un logement peuvent généralement avoir accès à leur consommation électrique globale, grâce à un compteur de consommation électrique équipant la ligne de raccordement au réseau public de distribution qui alimente le logement. Lorsque l'on souhaite connaître une consommation individuelle par exemple d'un équipement au sein du logement, on équipe d'un compteur de consommation électrique la branche dans laquelle est connecté cet équipement. La figure 6 annexée est un schéma représentant un exemple actuel d'installation électrique domestique, dans lequel plusieurs compteurs de consommation électrique 101 renseignent sur plusieurs consommations individuelles constitutives d'une consommation électrique globale.

Sur cette figure 6, la référence 102 désigne un transformateur de raccordement à un réseau public de distribution d'énergie électrique. Une arrivée amont équipée d'un compteur de consommation électrique 103 raccorde l'installation électrique à ce transformateur 102. Identique ou semblable au compteur 103, chaque compteur de consommation électrique 101 équipe l'un de plusieurs départs de distribution d'énergie électrique à plusieurs charges 104. Un réseau filaire est prévu pour acheminer les différents comptages à une centrale électronique de mesure 105, qui rassemble ces comptages.

Un compteur de consommation électrique est à la fois coûteux et encombrant. Lorsque l'on souhaite pouvoir suivre plusieurs consommations individuelles à l'intérieur d'une installation, le surcoût résultant de la multiplication des compteurs de consommation électrique devient conséquent et peut constituer un véritable frein à une véritable mise en place d'un système de suivi de consommations individuelles. La possibilité d'une telle multiplication de compteurs peut en outre se heurter au manque d'espace disponible dans nombre de tableaux généraux électriques actuellement en service chez les particuliers.

D'autres dispositifs de comptage décrits dans les documents EP2026299 et WO2011/002725 concernent des mesures d'énergie par reconnaissance de charges basées sur la détection de signaux transitoires.

**Objet de l'invention**

L'invention a au moins pour but de permettre une réduction du coût d'accès à la connaissance d'une consommation électrique individuelle constitutive d'une consommation électrique globale mesurée, au sein d'une installation électrique en courant alternatif.

Selon l'invention, ce but est atteint grâce à un procédé du type précité comprenant en outre l'action d'effectuer dans le temps et d'enregistrer des mesures de l'intensité d'un courant individuel particulier circulant dans une branche particulière parmi les branches du groupe. Le procédé selon l'invention est défini dans la revendication 1. L'invention tire parti de la constatation selon laquelle des informations peuvent être déduites d'un changement de la puissance consommée dans une branche, si l'on combine des données sur le fonctionnement avant le changement avec des données sur le fonctionnement après ce changement.

Le procédé selon l'invention permet de déterminer une puissance individuelle dans une branche particulière parmi plusieurs branches, à partir de mesures d'intensité dans cette branche particulière, dès lors que l'on dispose des valeurs caractérisant l'alimentation électrique globale de l'ensemble des branches. Notamment, la puissance individuelle consommée dans la branche particulière est déterminée en l'absence d'une mesure directe du déphasage du courant dans cette branche particulière, alors qu'un calcul direct d'une puissance électrique repose, en courant sinusoïdal, sur une connaissance de la tension entre deux bornes, de l'intensité du courant circulant entre ces deux bornes et du déphasage entre la tension et le courant.

La disponibilité d'une mesure des grandeurs caractérisant l'alimentation électrique globale d'un ensemble de plusieurs branches en parallèle est un cas courant en distribution électrique. Ce cas est notamment celui des installations électriques dans lesquelles plusieurs départs sont connectés à une même arrivée de raccordement à un réseau public de distribution d'énergie électrique et dans lesquelles cette arrivée est équipée d'un compteur de consommation d'énergie électrique. Dans un tel cas, le procédé selon l'invention permet de n'équiper que d'un ampèremètre la branche particulière dont on veut suivre la consommation. Or, un ampèremètre est généralement bien moins coûteux et moins encombrant qu'un compteur de consommation d'énergie électrique.

Le procédé de détermination d'une consommation électrique selon l'invention peut incorporer une ou plusieurs autres caractéristiques avantageuses, isolément ou en combinaison, en particulier parmi celles définies ci-après.

Avantageusement, dans la sous-étape b) de la revendication 1, on détermine ladite somme sensiblement inchangée de courants individuels comme satisfaisant simultanément auxdites deux conditions.

Avantageusement, dans la sous-étape b) de la revendication 1, on détermine ladite somme sensiblement inchangée de courants individuels en résolvant numériquement un système de deux équations à deux inconnues, qui est le suivant :

$$\begin{cases}(X_A - X_S)^2 + (Y_A - Y_S)^2 = I_{3A}^2 \\ (X_B - X_S)^2 + (Y_B - Y_S)^2 = I_{3B}^2\end{cases}$$

où $I_{3A}^2$ et $I_{3B}^2$ sont respectivement une mesure au carré de l'intensité du courant individuel particulier avant le changement et une mesure au carré de l'intensité du courant individuel particulier après le changement,

où $X_A$ et $Y_A$ sont respectivement l'abscisse et l'ordonnée de la représentation vectorielle du courant global tel que mesuré avant le changement, dans un diagramme de Fresnel,

où $X_B$ et $Y_B$ sont respectivement l'abscisse et l'ordonnée de la représentation vectorielle du courant global tel que mesuré après le changement, dans le diagramme de Fresnel,

et où $X_S$ et $Y_S$ sont deux inconnues et sont respectivement l'abscisse et l'ordonnée de la représentation vectorielle de ladite somme sensiblement inchangée de courants individuels, dans le diagramme de Fresnel, avant et après le changement.

Avantageusement, l'étape b) de la revendication 1 comprend des sous-étapes dans lesquelles :

- on détermine une valeur d'intensité AB au moyen de la relation suivante :

$$AB = \sqrt{I_A^2 + I_B^2 - 2 \times I_A \times I_B \times \cos\left(\psi_B - \psi_A\right)}$$

où $I_A$ et $\psi_A$ sont respectivement une intensité et un déphasage mesurés du courant global avant le changement et où $I_B$ et $\psi_B$ sont respectivement une intensité et un déphasage mesurés du courant global après le changement,

- on détermine une valeur d'angle $\psi_1$ au moyen de la relation suivante :

$$\psi_1 = \arcsin\left(\frac{I_B \times \cos\psi_B - I_A \times \cos\psi_A}{AB}\right),$$

- on détermine une valeur d'angle $\psi_2$ au moyen de la relation suivante :

$$\psi_2 = \arccos\left(\frac{I_{3B}^2 + AB^2 - I_{3A}^2}{2 \times I_{3B} \times AB}\right)$$

où $I_{3A}$ et $I_{3B}$ sont respectivement une mesure de l'intensité du courant individuel particulier avant le changement et une mesure de l'intensité du courant individuel particulier après le changement.

Avantageusement, l'étape b) de la revendication 1 comprend une sous-étape dans laquelle :

- on détermine la puissance individuelle particulière après le changement au moyen de la relation suivante :

$$P_{3B} = U \times I_{3B} \times \sin\left(\psi_1 + \psi_2\right)$$

où $P_{3B}$ et U sont respectivement ladite puissance individuelle particulière après le changement et la mesure de la tension globale.

Avantageusement, le procédé de détermination d'une consommation de puissance comprend une étape dans laquelle :

- on détermine le déphasage du courant individuel particulier après le changement, au moyen de la relation suivante :

$$\psi_{3B} = \pi / 2 - \left(\psi_1 + \psi_2\right)$$

où $\psi_{3B}$ est le déphasage du courant individuel particulier après le changement.

Avantageusement, dans l'étape b), on élimine une solution aberrante parmi deux solutions possibles.

L'invention a également pour objet une installation électrique du type précité dont le système de supervision est adapté pour effectuer dans le temps et enregistrer des mesures de l'intensité d'un courant individuel particulier circulant dans une branche particulière parmi les branches du groupe, le système de supervision comportant un dispositif calculateur à même :

- de détecter un changement quant à la consommation électrique dans la branche particulière,
- en utilisant une mesure de la tension globale sensiblement constante pendant le changement, des mesures des valeurs d'intensité et de déphasage du courant global avant et après le changement, ainsi que des mesures des intensités du courant individuel particulier avant et après le changement, de déterminer une puissance individuelle particulière consommée dans la branche particulière, ledit dispositif calculateur comprenant des moyens pour conduire un procédé selon l'une quelconque des revendications 1 à 7.

L'installation électrique selon l'invention peut incorporer une ou plusieurs autres caractéristiques avantageuses, isolément ou en combinaison. En particulier, le dispositif calculateur est avantageusement à même de conduire un procédé tel que défini précédemment.

**Description sommaire des dessins**

D'autres avantages et caractéristiques ressortiront plus clairement de la description qui va suivre de modes particuliers de réalisation de l'invention donnés à titre d'exemples non limitatifs et représentés aux dessins annexés, parmi lesquels :

- la figure 1 est un schéma électrique simplifié d'une installation électrique conforme à l'invention ;
- la figure 2 est un organigramme de la logique de fonctionnement d'un procédé qui est mis en oeuvre dans le cadre d'une détermination d'une consommation individuelle constitutive de la consommation globale de l'installation électrique de la figure 1 ;
- la figure 3 est un diagramme de Fresnel illustrant comment procède une étape d'un procédé conforme à l'invention et prévu pour déterminer la consommation individuelle précitée ;
- la figure 4 est un diagramme de Fresnel qui reprend celui de la figure 3 et qui indique en outre des détails complémentaires concernant une opération incluse dans une première façon d'effectuer l'étape schématisée à cette figure 3 ;
- la figure 5 est un diagramme de Fresnel qui reprend également celui de la figure 3 et qui indique en outre des détails complémentaires concernant une deuxième façon d'effectuer l'étape schématisée à cette figure 3.

Les figures annexées comptent en outre une figure 6, qui est un schéma électrique simplifié d'une installation électrique selon un art antérieur à l'invention.

**Description d'un mode préférentiel de l'invention**

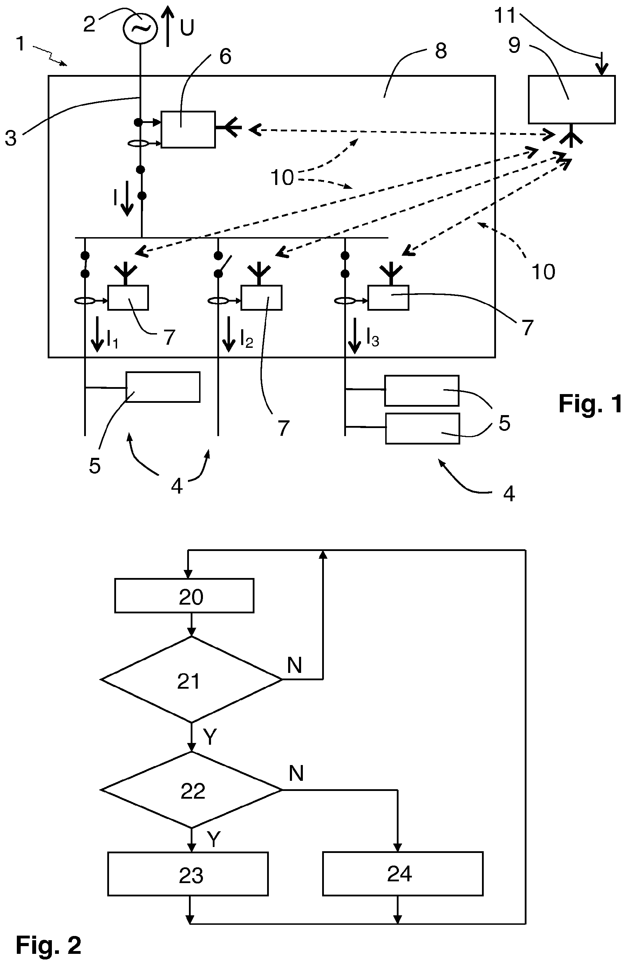

Sur la figure 1 est représentée une installation électrique 1 adaptée pour une mise en oeuvre d'un procédé conforme à l'invention. Dans un souci de clarté, la figure 1 est simplifiée et certains constituants classiques y sont omis. En particulier, la phase seule est représentée, alors que le neutre ne l'est pas.

L'installation électrique 1 peut appartenir à un consommateur final et se trouver dans un ensemble ou un bâtiment, tel qu'un bâtiment d'habitation ou un immeuble de bureaux, où il existe plusieurs charges distinctes à alimenter et où il y a lieu d'effectuer une distribution d'énergie électrique. Cette installation électrique 1 peut notamment être celle d'une maison individuelle ou celle d'un logement de particuliers.

L'installation électrique 1 est alimentée par une alimentation électrique en courant alternatif sinusoïdal 2, à laquelle elle est raccordée par une arrivée 3 et qui peut notamment être un réseau public de distribution d'énergie électrique.

Plusieurs départs sont connectés à l'arrivée 3. Chacun d'eux fait partie de l'une de plusieurs branches 4 montées en parallèle, dans lesquelles sont connectées des charges 5 à alimenter. Dans l'exemple représenté, ces branches 4 sont au nombre de trois. Il va de soi que leur nombre peut être différent de trois.

L'arrivée 3 est équipée d'un compteur de consommation d'énergie électrique 6, qui mesure dans le temps plusieurs grandeurs caractéristiques de la fourniture électrique globale au groupe de branches 4, à savoir la tension globale d'alimentation U, ainsi que les valeurs d'intensité et de déphasage du courant global d'alimentation I circulant dans l'arrivée 3.

Une ou plusieurs branches 4 sont équipées chacune d'un capteur de courant ou ampèremètre 7. Dans l'exemple représenté, un ampèremètre 7 mesure l'intensité du courant individuel $I_1$, $I_2$ ou $I_3$ dans chaque branche 4. La référence 8 désigne un tableau général basse tension où sont regroupés plusieurs appareils électriques, y compris le compteur de consommation 6 et les ampèremètres 7.

Un dispositif calculateur 9 recueille et enregistre dans le temps, c'est-à-dire tout du long du fonctionnement de l'installation électrique 1, des mesures effectuées par l'instrumentation de mesure, à savoir le compteur de consommation 6 et les ampèremètres 7, qui échangent avec lui au moyen d'une communication sans fil, telle qu'une communication hertzienne, symbolisée par les flèches 10. Même si une communication sans fil est préférée, la communication entre l'instrumentation de mesure et le dispositif calculateur 9 peut être filaire voire mixte. Le dispositif calculateur 9 est équipé d'au moins un port d'entrée/sortie 11, au moyen duquel il peut communiquer avec un dispositif extérieur tel qu'un ordinateur de configuration, de supervision, de contrôle et/ou de pilotage.

Le compteur de consommation 6, les ampèremètres 7 et le dispositif calculateur 9 forment ensemble tout ou partie d'un système de supervision du fonctionnement de l'installation électrique 1.

Le dispositif calculateur 9 conduit le procédé dont la logique est représentée à la figure 2. Ce procédé convient pour les branches 4 dans lesquelles les changements de consommation de puissance se font par palier, du fait de la nature de leurs charges 5. En d'autres termes, il convient lorsque la puissance consommée dans une branche 4 est sensiblement stable entre deux changements.

A une première étape 20 du procédé schématisé à la figure 2, le dispositif calculateur 9 surveille les apparitions de changements affectant les intensités des courants dans les branches 4 et/ou la consommation globale de l'installation électrique 1. Lorsqu'un tel changement a été détecté, le dispositif calculateur 9 passe à une étape 21, dans laquelle il réalise un filtrage distinguant les changements significatifs et durables des autres changements, insignifiants et/ou passagers.

Les changements significatifs sont définis comme supérieurs à un seuil prédéterminé qui est choisi en tenant compte de diverses données comme le type d'emploi de l'installation électrique 1. Les changements passagers sont définis comme ayant une durée supérieure à une temporisation prédéterminée, par exemple de l'ordre de 2 à 3 s. Dans le cas où il est répondu par la négative à la question de savoir si le changement détecté est significatif et durable, le dispositif calculateur 9 revient à l'étape de surveillance 20. Dans le cas contraire, une étape 22 est entamée.

Après avoir utilisé les mesures des intensités des courants individuels $I_1$ à $I_3$ pour déterminer dans quelle branche 4 a eu lieu la variation de consommation de puissance à l'origine du changement détecté, le dispositif calculateur 9 répond à une nouvelle question à l'étape 22. Cette question consiste à se demander si le courant dans la branche 4 affecté par le changement de consommation était nul ou non avant le changement.

Dans le cas où l'ancien courant individuel dans la branche 4 affecté par le changement de consommation était nul, un calcul simplifié est mené à l'étape 23 et consiste à déterminer la puissance individuelle consommée dans cette branche après le changement comme étant égale à la variation de la puissance globale consommée par l'installation électrique et déterminé par le compteur de consommation 6 ou à partir de ses seules mesures des grandeurs caractéristiques de l'alimentation électrique globale du groupe de branches 4, c'est-à-dire des valeurs de tension, d'intensité et de déphasage de cette alimentation.

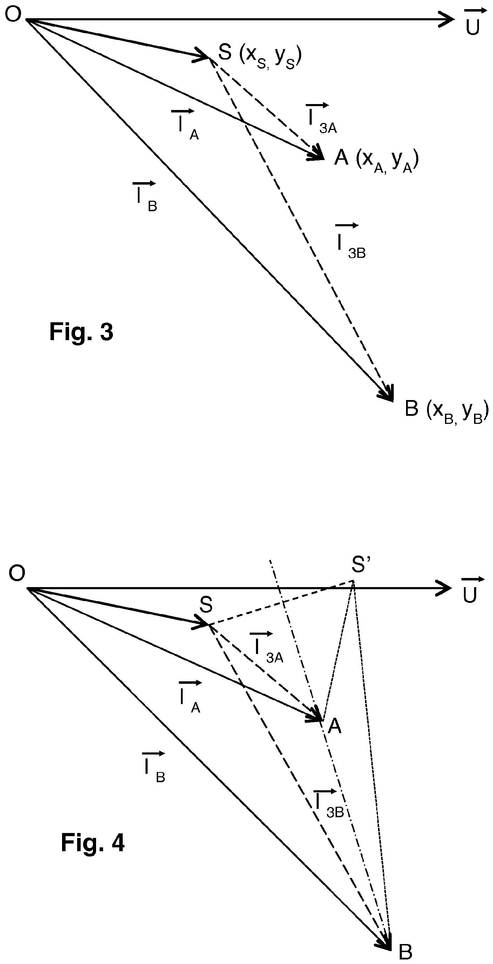

Si le courant individuel dans la branche 4 où s'est produit le changement de consommation de puissance n'était pas nul avant le changement, le dispositif calculateur 9 exécute l'étape 24, dans laquelle il détermine la nouvelle puissance individuelle consommée dans cette branche 4, en procédant d'une manière qui est explicitée ci-dessous à l'aide du diagramme de Fresnel de la figure 3.

Cette manière de procéder considère que l'installation électrique 1 est alimentée par un courant sensiblement sinusoïdal, avec pas ou peu de distorsions harmoniques. En cas de distorsions harmoniques, la puissance individuelle déterminée par le dispositif calculateur 9 sera moins précise.

Au moins dans les formules de calcul de puissance présentes dans ce qui suit et/ou dans les revendications annexées, les valeurs de tension et d'intensité mentionnées sont des valeurs efficaces.

La figure 3 considère plus précisément le cas d'un changement de consommation de puissance se produisant dans la branche 4 où circule le courant individuel $I_3$. Représentée par le vecteur $\vec{U}$ à la figure 3, la tension aux bornes de chaque branche 4 est la tension globale U d'alimentation de l'installation 1. Le changement de consommation de puissance n'a qu'un effet très faible sinon insignifiant sur elle. De ce fait, on considère que cette tension globale U n'est pas modifiée lors du changement de consommation de puissance. En revanche, ce changement affecte le courant global I comme le courant individuel $I_3$.

Sur la figure 3, le vecteur $\vec{I}_A$ et le vecteur $\vec{I}_{3A}$ sont respectivement la représentation graphique du courant global I et la représentation graphique du courant individuel $I_3$ à un même instant, qui est un premier instant se situant avant le changement. Le vecteur $\vec{I}_B$ et le vecteur $\vec{I}_{3B}$ sont respectivement la représentation graphique du courant global I et la représentation graphique du courant individuel $I_3$ à un autre même instant, qui est un deuxième instant se situant après le changement. Le premier comme le deuxième instant sont choisis hors de la phase de changement proprement dite. En d'autres termes, chacun d'eux se trouve dans une phase de fonctionnement stabilisé et constant de l'installation électrique 1, de manière que les transitoires en soient exclus.

Les valeurs de tension, d'intensité et de déphasage mesurées par le compteur 6 déterminent les vecteurs $\vec{U}$, $\vec{I}_A$ et $\vec{I}_B$, qui sont donc connus. En revanche, les grandeurs caractérisant le courant individuel $I_3$ ne sont pas toutes mesurées. En effet, seules les intensités le sont, à l'exception des déphasages, en ce qui concerne ce courant individuel $I_3$.

Une variation de puissance ne s'est produite que dans la branche 4 où circule le courant $I_3$. L'ensemble des courants individuels circulant dans les autres branches 4, à l'exception donc du courant individuel $I_3$, s'additionnent en une somme sensiblement inchangée entre le premier instant avant le changement de consommation de puissance et le deuxième instant après ce changement. Dans l'exemple considéré, cette somme est la somme des courants $I_1$ et $I_2$. Sa représentation graphique à la figure 3 est le vecteur $\overrightarrow{OS}$, où O est l'origine d'un repère orthonormé.

Comme ce vecteur $\overrightarrow{OS}$ est le même avant et après le changement, il doit être satisfait à la fois :

- que $\overrightarrow{OS} + \vec{I}_{3A} = \vec{I}_A (= \overrightarrow{OA})$ , et

- que $\overrightarrow{OS} + \vec{I}_{3B} = \vec{I}_B (= \overrightarrow{OB})$.

C'est ce qu'illustre la figure 3.

La norme du vecteur $\vec{I}_{3A}$ est la mesure $I_{3A}$ de l'intensité du courant $I_3$ avant le changement. La norme du vecteur $\vec{I}_{3B}$ est la mesure $I_{3B}$ de l'intensité du courant $I_3$ après le changement. Le point S est à l'intersection de deux cercles, à savoir un cercle de centre A et de rayon l'intensité $I_{3A}$ du courant $I_3$ telle que mesurée avant le changement et un cercle de centre B et de rayon l'intensité $I_{3B}$ du courant $I_3$ telle que mesurée après le changement.

Sur la base de ce qui précède, une première manière de procéder est de résoudre numériquement un système de deux équations à deux inconnues, qui est le suivant :

$$\begin{cases} (X_A - X_S)^2 + (Y_A - Y_S)^2 = I_{3A}^2 \\ (X_B - X_S)^2 + (Y_B - Y_S)^2 = I_{3B}^2 \end{cases} \qquad (1)$$

$X_A$ et $Y_A$ sont les coordonnées cartésiennes du vecteur $\vec{I}_A$ dans le repère orthonormé précité, dont seule l'origine O est représentée dans un souci de clarté.

$X_B$ et $Y_B$ sont les coordonnées cartésiennes du vecteur $\vec{I}_B$ dans le même repère orthonormé.

$X_s$ et $Y_s$ sont deux inconnues et sont les coordonnées cartésiennes du vecteur $\overrightarrow{OS}$, toujours dans le même repère orthonormé.

Le dispositif calculateur 9 peut résoudre le système (1) de deux équations à deux inconnues au moyen d'une méthode mathématique de résolution numérique qui est basée sur une variation progressive de $X_S$ et $Y_S$, en étant contrôlée par un critère de convergence pertinent.

Par exemple, une méthode numérique de détermination du point S peut consister à se déplacer pas à pas sur l'un des deux cercles précités, qui sont le cercle de centre A et de rayon l'intensité $I_{3A}$ et le cercle de centre B et de rayon l'intensité $I_{3B}$. A chaque pas sur l'un des cercles, on vérifie si l'on se trouve ou non dans le voisinage immédiat de l'autre cercle.

Il convient de noter que le système (1) possède deux solutions qui correspondent aux points S et S' à la figure 4. Le point S' correspond à une solution aberrante physiquement, qui doit être éliminée pour ne conserver que l'autre solution, celle correspondant au point S.

L'élimination du point S' peut se faire en calculant, pour chacun des points S et S', les puissances actives et réactives avant et après la variation de puissance observée et en ne retenant que celui des deux points S et S' pour lequel ces puissances répondent aux critères suivants :

- les puissances actives avant et après la variation de puissance doivent être positives, étant considéré que les charges 5 sont supposées consommer et non pas fournir de la puissance active,
- les puissances réactives avant et après la variation de puissance doivent être de même signe et cohérentes avec la nature de la ou des charges 5 dans la branche 4, à savoir positives en cas de charges 5 capacitives et négatives en cas de charge 5 selfiques.

Une fois que le point S est déterminé, on détermine aisément le vecteur $\vec{I}_{3B}$ et les valeurs d'intensité et de déphasage caractéristiques du nouveau courant $I_3$, au moyen de la relation suivante : $\vec{I}_{3B} = \vec{I}_B - \overrightarrow{OS}$ .

La nouvelle puissance $P_{3B}$, c'est-à-dire celle postérieure au changement et consommée dans la branche 4 où circule le courant $I_3$, est ensuite calculée par le dispositif calculateur 9, comme étant le produit scalaire des vecteurs $\vec{U}$ et $\vec{I}_{3B}$ : $P_{3B} = \vec{U} \bullet \vec{I}_{3B}$. L'ancienne puissance $P_{3A}$ dans cette branche 4 peut également être calculée, de manière semblable, à savoir au moyen de la relation $P_{3A} = \vec{U} \bullet \vec{I}_{3A}$.

La figure 5 illustre des relations géométriques et trigonométriques qui sont employées dans une deuxième manière de procéder pour déterminer la puissance consommée dans la branche 4 où circule le courant $I_3$. A la place ou en complément de la première manière de procéder exposée précédemment, le dispositif calculateur 9 peut mettre en oeuvre cette deuxième manière de procéder, qui repose sur un calcul analytique et qui va maintenant être exposée.

Dans le triangle AOB visible à la figure 5, on a la relation suivante :

$$AB^2 = I_A^2 + I_B^2 - 2 \times I_A \times I_B \times \cos(angle AOB) \qquad (2)$$

$I_A$ et $I_B$ sont respectivement une mesure de l'intensité de l'ancien courant global I (avant le changement) et une mesure de l'intensité du nouveau courant global I (après le changement).

De la relation (2), on déduit l'égalité suivante :

$$AB = \sqrt{I_A^2 + I_B^2 - 2 \times I_A \times I_B \times \cos\left(\psi_B - \psi_A\right)} \qquad (3)$$

$\psi_A$ et $\psi_B$ sont respectivement une mesure du déphasage de l'ancien courant global I et une mesure du déphasage du nouveau courant global I.

Selon la deuxième manière de procéder, le dispositif calculateur 9 détermine la valeur d'intensité AB au moyen de l'égalité (3).

Par ailleurs, on a la relation suivante :

$$P_B - P_A = U \times AB \times \sin(\psi_1) \qquad (4)$$

$P_A$ est l'ancienne puissance globale consommée par l'installation électrique 1, c'est-à-dire par l'ensemble des branches 4, telle que mesurée par le compteur 6 avant le changement. $P_B$ est la nouvelle puissance globale consommée par cette installation électrique 1, telle que mesurée par le compteur 6 après le changement. U est une mesure de la tension globale aux bornes du groupe de branches 4.

De la relation (4), on déduit l'égalité suivante :

$$\psi_1 = \arcsin\left(\frac{I_B \times \cos\psi_B - I_A \times \cos\psi_A}{AB}\right) \qquad (5)$$

Selon la deuxième manière de procéder, le dispositif calculateur 9 détermine la valeur d'angle $\psi_1$ au moyen de l'égalité (5).

Dans le triangle ABS visible à la figure 5, on a la relation suivante :

$$SA^2 = SB^2 + AB^2 - 2 \times SB \times AB \times \cos\psi_2 \qquad (6)$$

De la relation (6), on déduit l'égalité suivante :

$$\psi_2 = \arccos\left(\frac{I_{3B}^2 + AB^2 - I_{3A}^2}{2 \times I_{3B} \times AB}\right) \qquad (7)$$

Selon la deuxième manière de procéder, le dispositif calculateur 9 détermine la valeur d'angle $\psi_2$ au moyen de l'égalité (7).

Par ailleurs, on a la relation suivante :

$$SH = SB \times \sin(\psi_1 + \psi_2) \qquad (8)$$

De la relation (8), on déduit l'égalité suivante :

$$P_{3B} = U \times I_{3B} \times \sin(\psi_1 + \psi_2) \qquad (9)$$

Selon la deuxième manière de procéder, le dispositif calculateur 9 utilise l'égalité (9) pour déterminer la nouvelle puissance individuelle $P_{3B}$ dans la branche 4 où circule le courant $I_3$.

Bien entendu, les formules employées peuvent présenter une autre forme que les égalités (3), (5), (7) et (9), tout en restant dans le cadre de la deuxième manière de procéder qui vient d'être exposée. Par exemple, les égalités (3), (5), (7) et (9) peuvent être combinées dans le sens d'une réduction du nombre de formules employées. Notamment, l'égalité (3) peut être incorporée dans l'égalité (5), ainsi que dans l'égalité (7), tandis que ces égalités (5) et (7) peuvent être incorporées dans l'égalité (9).

Le dispositif calculateur 9 peut également déterminer le déphasage $\psi_{3B}$ du nouveau courant $I_3$, c'est-à-dire du courant $I_3$ après le changement, au moyen de la relation suivante :

$$\psi_{3B} = \pi/2 - (\psi_1 + \psi_2) \qquad (10)$$

Le dispositif calculateur 9 peut également déterminer l'ancienne puissance individuelle $P_{3A}$, c'est-à-dire la puissance consommée avant le changement, dans la branche 4 où circule le courant $I_3$. Pour ce faire, il peut employer la relation suivante :

$$P_{3A} = P_{3B} - (P_B - P_A) \qquad (11)$$

Le dispositif calculateur 9 peut également déterminer la nouvelle puissance individuelle réactive $Q_{3B}$, c'est-à-dire la puissance réactive après le changement, dans la branche 4 où circule le courant $I_3$. Pour ce faire, il peut employer la relation suivante :

$$Q_{3B} = U \times I_{3B} \times \cos(\psi_1 + \psi_2) \qquad (12)$$

Le dispositif calculateur 9 peut également déterminer l'ancienne puissance individuelle réactive $Q_{3A}$, c'est-à-dire la puissance réactive avant le changement, dans la branche 4 où circule le courant $I_3$. Pour ce faire, il peut employer la relation suivante :

$$Q_{3A} = Q_{3B} - (Q_B - Q_A) \qquad (13)$$

Comme la première manière de procéder utilisant une résolution numérique, la deuxième manière de procéder reposant sur une résolution trigonométrique donne deux solutions qui correspondent aux points S et S' de la figure 4. Ces deux solutions viennent de ce que le calcul d'arcsinus dans la formule (5) peut se voir attribuer une valeur positive ou négative. La solution aberrante correspondant au point S' est éliminée dans la deuxième manière de procéder comme elle l'est dans la première manière de procéder.

A partir de leurs exposés ci-dessus dans le cas du monophasé, les deux manières possibles de procéder à l'étape 24 peuvent être transposées sans difficulté particulière au cas d'une installation électrique pour courants polyphasés. Dans un souci de clarté, leurs transpositions à ce cas d'une installation électrique pour courants polyphasés ne sont pas détaillées ici.

L'invention ne se limite pas aux modes de réalisation décrits précédemment. En particulier, elle ne se limite pas au cas d'un courant alternatif monophasé, mais peut au contraire également être mise en oeuvre dans des installations électriques pour courants polyphasés. De plus, le domaine de l'invention couvre aussi bien la moyenne et la haute tension que la basse tension, même si l'exemple décrit précédemment se situe dans le domaine de la basse tension.

## Revendications

**1.** Procédé de détermination d'une consommation de puissance dans une installation électrique (1), dans laquelle un groupe de plusieurs branches de distribution individuelle (4) connectées en parallèle est raccordé à une alimentation en courant alternatif (2), le procédé comprenant l'action d'effectuer dans le temps et d'enregistrer des mesures de la tension globale (U) d'alimentation du groupe de plusieurs branches (4), ainsi que des mesures des valeurs d'intensité et de déphasage ($I_A$, $I_B$, $\psi_A$, $\psi_B$) du courant global (1) d'alimentation du groupe de plusieurs branches (4), **caractérisé en ce que** le procédé comprend l'action d'effectuer dans le temps et d'enregistrer des mesures de l'intensité ($I_{3A}$, $I_{3B}$) d'un courant individuel particulier ($I_3$) circulant dans une branche particulière (4) parmi les branches du groupe, le procédé comportant des étapes dans lesquelles :

a) on détecte un changement quant à la consommation électrique dans la branche particulière (4), et
b) en utilisant une mesure de la tension globale (U) sensiblement constante pendant le changement, des mesures des valeurs d'intensité et de déphasage ($I_A$, $I_B$, $\psi_A$, $\psi_B$) du courant global (I) avant et après le changement, ainsi que des mesures des intensités ($I_{3A}$, $I_{3B}$) du courant individuel particulier ($I_3$) avant et après le changement, on détermine une puissance individuelle particulière consommée dans la branche particulière (4), dans ladite l'étape b), on détermine la puissance individuelle particulière en considérant que l'ensemble ($I_1$, $I_2$) des courants individuels circulant dans les branches (4) du groupe à l'exception du courant individuel particulier ($I_3$) s'additionnent en une somme sensiblement inchangée à l'issue du changement, par rapport à avant le changement, et que doivent être simultanément satisfaites deux conditions qui sont :

- que le courant global (I) avant le changement doit être sensiblement égal à l'ajout de la somme sensiblement inchangée au courant individuel particulier ($I_3$) avant le changement, et
- que le courant global (I) après le changement doit être sensiblement égal à l'ajout de la somme sensiblement inchangée au courant individuel particulier ($I_3$) après le changement,

ladite étape b) comportant des sous-étapes dans lesquelles :

b1) en utilisant des mesures des valeurs d'intensité et de déphasage ($I_A$, $I_B$, $\psi_A$, $\psi_B$) du courant global (I) avant et après le changement, ainsi que des mesures des intensités ($I_{3A}$, $I_{3B}$) du courant individuel particulier ($I_3$) avant et après le changement, on détermine ladite somme sensiblement inchangée de courants individuels ($I_1$, $I_2$),

b2) on détermine quelle composante doit être ajoutée à la somme sensiblement inchangée de courants individuels ($I_1$, $I_2$) pour obtenir le courant global ($I$), cette composante étant une détermination du courant individuel particulier ($I_3$),

b3) on calcule la puissance individuelle particulière comme étant le produit de la tension globale et du courant individuel particulier.

2. Procédé selon la revendication 1, **caractérisé en ce que**, dans la sous-étape b1), on détermine ladite somme sensiblement inchangée de courants individuels ($I_1$, $I_2$) comme satisfaisant simultanément auxdites deux conditions.

3. Procédé selon la revendication 2, **caractérisé en ce que**, dans la sous-étape b1), on détermine ladite somme sensiblement inchangée de courants individuels ($I_1$, $I_2$) en résolvant numériquement un système de deux équations à deux inconnues, qui est le suivant :

$$\begin{cases} (X_A - X_S)^2 + (Y_A - Y_S)^2 = I_{3A}^2 \\ (X_B - X_S)^2 + (Y_B - Y_S)^2 = I_{3B}^2 \end{cases}$$

où $I_{3A}^2$ et $I_{3B}^2$ sont respectivement une mesure au carré de l'intensité du courant individuel particulier ($I_3$) avant le changement et une mesure au carré de l'intensité du courant individuel particulier ($I_3$) après le changement,

où $X_A$ et $Y_A$ sont respectivement l'abscisse et l'ordonnée de la représentation vectorielle ($\vec{I_A}$) du courant global ($I$) tel que mesuré avant le changement, dans un diagramme de Fresnel,

où $X_B$ et $Y_B$ sont respectivement l'abscisse et l'ordonnée de la représentation vectorielle ($\vec{I_B}$) du courant global ($I$) tel que mesuré après le changement, dans le diagramme de Fresnel,

et où $X_S$ et $Y_S$ sont deux inconnues et sont respectivement l'abscisse et l'ordonnée de la représentation vectorielle de ladite somme sensiblement inchangée de courants individuels ($I_1$, $I_2$), dans le diagramme de Fresnel, avant et après le changement.

4. Procédé selon l'une quelconque des revendications 1 à 3, **caractérisé en ce que** l'étape b) comprend des sous-étapes dans lesquelles :

- on détermine une valeur d'intensité AB au moyen de la relation suivante :

$$AB = \sqrt{I_A^2 + I_B^2 - 2 \times I_A \times I_B \times \cos(\psi_B - \psi_A)}$$

où $I_A$ et $\psi_A$ sont respectivement une intensité et un déphasage mesurés du courant global ($I$) avant le changement et où $I_B$ et $\psi_B$ sont respectivement une intensité et un déphasage mesurés du courant global ($I$) après le changement,

- on détermine une valeur d'angle $\psi_1$ au moyen de la relation suivante :

$$\psi_1 = \arcsin\left(\frac{I_B \times \cos\psi_B - I_A \times \cos\psi_A}{AB}\right),$$

- on détermine une valeur d'angle $\psi_2$ au moyen de la relation suivante :

$$\psi_2 = \arccos\left(\frac{I_{3B}^2 + AB^2 - I_{3A}^2}{2 \times I_{3B} \times AB}\right)$$

où $I_{3A}$ et $I_{3B}$ sont respectivement une mesure de l'intensité du courant individuel particulier ($I_3$) avant le changement et une mesure de l'intensité du courant individuel particulier ($I_3$) après le changement.

5. Procédé selon la revendication 4, **caractérisé en ce que** l'étape b) comprend une sous-étape dans laquelle :

- on détermine la puissance individuelle particulière après le changement au moyen de la relation suivante :

$$P_{3B} = U \times I_{3B} \times \sin\left(\psi_1 + \psi_2\right)$$

où $P_{3B}$ et U sont respectivement ladite puissance individuelle particulière après le changement et la mesure de la tension globale (U).

**6.** Procédé selon l'une quelconque des revendications 4 et 5, **caractérisé en ce qu'**il comprend une étape dans laquelle :

- on détermine le déphasage du courant individuel particulier ($I_3$) après le changement, au moyen de la relation suivante :

$$\psi_{3B} = \pi / 2 - \left(\psi_1 + \psi_2\right)$$

où $\psi_{3B}$ est le déphasage du courant individuel particulier ($I_3$) après le changement.

**7.** Procédé selon l'une quelconque des revendications précédentes, **caractérisé en ce que**, dans l'étape b), on élimine une solution aberrante (S') parmi deux solutions possibles (S, S').

**8.** Installation électrique en courant alternatif, comportant un groupe de plusieurs branches de distribution individuelle (4) connectées en parallèle. ainsi qu'un système de supervision (6, 7, 9) adapté pour effectuer dans le temps et enregistrer des mesures d'une tension globale (U) d'alimentation du groupe de plusieurs branches (4), ainsi que des mesures des valeurs d'intensité et de déphasage ($I_A$, $I_B$, $\psi_A$, $\psi_B$) d'un courant global (I) d'alimentation du groupe de plusieurs branches (4), **caractérisée en ce que** le système de supervision (6, 7, 9) est adapté pour effectuer dans le temps et enregistrer des mesures de l'intensité ($I_{3A}$, $I_{3B}$) d'un courant individuel particulier ($I_3$) circulant dans une branche particulière (4) parmi les branches du groupe, le système de supervision comportant un dispositif calculateur (9) à même :

- de détecter un changement quant à la consommation électrique dans la branche particulière (4), et
- en utilisant une mesure de la tension globale (U) sensiblement constante pendant le changement, des mesures des valeurs d'intensité et de déphasage ($I_A$, $I_B$, $\psi_A$, $\psi_B$) du courant global (I) avant et après le changement, ainsi que des mesures des intensités ($I_{3A}$, $I_{3B}$) du courant individuel particulier ($I_3$) avant et après le changement, de déterminer une puissance individuelle particulière consommée dans la branche particulière (4).

ledit dispositif calculateur (9) comprenant des moyens pour conduire un procédé selon l'une quelconque des revendications 1 à 7.

**Patentansprüche**

**1.** Verfahren zum Bestimmen eines Leistungsverbrauchs in einer elektrischen Anlage (1), wobei eine Gruppe von mehreren Verzweigungen zur einzelnen Verteilung (4), die parallel geschaltet sind, mit einer Wechselstromversorgung (2) verbunden ist, wobei das Verfahren den Vorgang des Vornehmens in der Zeit und des Aufzeichnens von Messungen der Gesamtversorgungsspannung (U) der Gruppe von mehreren Verzweigungen (4) sowie von Messungen von Intensitäts- und Phasenverschiebungswerten ($I_A$, $I_B$, $\psi_A$, $\psi_B$) des Gesamtversorgungsstroms (I) der Gruppe von mehreren Verzweigungen (4) umfasst, **dadurch gekennzeichnet, dass** das Verfahren den Vorgang des Vornehmens in der Zeit und des Aufzeichnens von Messungen der Intensität ($I_{3A}$, $I_{3B}$) eines bestimmten einzelnen Stroms ($I_3$) umfasst, der in einer bestimmten Verzweigung (4) unter den Verzweigungen der Gruppe zirkuliert, wobei das Verfahren Schritte umfasst, in denen:

a) eine Änderung aufgrund des elektrischen Verbrauchs in der bestimmten Verzweigung (4) detektiert wird, und
b) unter Verwendung einer Messung der während der Änderung im Wesentlichen konstanten Gesamtspannung (U), von Messungen von Intensitäts- und Phasenverschiebungswerten ($I_A$, $I_B$, $\psi_A$, $\psi_B$) des Gesamtstroms (I) vor und nach der Änderung, sowie von Messungen der Intensitäten ($I_{3A}$, $I_{3B}$) des bestimmten einzelnen Stroms

($I_3$) vor und nach der Änderung, eine bestimmte einzelne Leistung bestimmt wird, die in der bestimmten Verzweigung (4) verbraucht wird,

wobei in Schritt b) die bestimmte einzelne Leistung bestimmt wird, indem berücksichtigt wird, dass die Gesamtheit ($I_1$, $I_2$) der einzelnen Ströme, die in den Verzweigungen (4) der Gruppe zirkulieren, mit Ausnahme des bestimmten einzelnen Stroms ($I_3$), mit einer Summe addiert wird, die nach der Änderung in Bezug auf vor der Änderung im Wesentlichen unverändert ist, und dass gleichzeitig zwei Bedingungen erfüllt sein müssen, die sind:

- dass der Gesamtstrom (I) vor der Änderung im Wesentlichen gleich der Addition der im Wesentlichen unveränderten Summe mit dem bestimmten einzelnen Strom ($I_3$) vor der Änderung sein muss, und
- dass der Gesamtstrom (I) nach der Änderung im Wesentlichen gleich der Addition der im Wesentlichen unveränderten Summe mit dem bestimmten einzelnen Strom ($I_3$) nach der Änderung sein muss,

wobei Schritt b) Teilschritte umfasst, in denen:

b1) unter Verwendung von Messungen von Intensitäts- und Phasenverschiebungswerten ($I_A$, $I_B$, $\psi_A$, $\psi_B$) des Gesamtstroms (I) vor und nach der Änderung, sowie von Messungen der Intensitäten ($I_{3A}$, $I_{3B}$) des bestimmten einzelnen Stroms ($I_3$) vor und nach der Änderung, die im Wesentlichen unveränderte Summe der einzelnen Ströme ($I_1$, $I_2$) bestimmt wird,
b2) bestimmt wird, welche Komponente mit der im Wesentlichen unveränderten Summe der einzelnen Ströme ($I_1$, $I_2$) addiert werden muss, um den Gesamtstrom (I) zu erhalten, wobei diese Komponente eine Bestimmung des bestimmten einzelnen Stroms ($I_3$) ist,
b3) die bestimmte einzelne Leistung als Produkt der Gesamtspannung und des bestimmten einzelnen Stroms berechnet wird.

2. Verfahren nach Anspruch 1, **dadurch gekennzeichnet, dass**, in dem Teilschritt b1), die im Wesentlichen unveränderte Summe der einzelnen Ströme ($I_1$, $I_2$) dahingehend bestimmt wird, dass sie die beiden genannten Bedingungen gleichzeitig erfüllt.

3. Verfahren nach Anspruch 2, **dadurch gekennzeichnet, dass**, in dem Teilschritt b1), die im Wesentlichen unveränderte Summe der einzelnen Ströme ($I_1$, $I_2$) dahingehend bestimmt wird, dass numerisch ein System von zwei Gleichungen mit zwei Unbekannten gelöst wird, welches das folgende ist:

$$\begin{cases} (X_A - X_S)^2 + (Y_A - Y_S)^2 = I_{3A}^2 \\ (X_B - X_S)^2 + (Y_B - Y_S)^2 = I_{3B}^2 \end{cases}$$

wobei $I_{3A}^2$ und $I_{3B}^2$ jeweils ein Quadratmaß der Intensität des bestimmten einzelnen Stroms ($I_3$) vor der Änderung und ein Quadratmaß der Intensität des bestimmten einzelnen Stroms ($I_3$) nach der Änderung sind,
wobei $X_A$ und $Y_A$ jeweils die Abszisse und die Ordinate der Vektordarstellung ($\vec{I_A}$) des Gesamtstroms (I), wie vor der Änderung gemessen, in einem Fresnel-Diagramm sind,
wobei $X_B$ und $Y_B$ jeweils die Abszisse und die Ordinate der Vektordarstellung ($\vec{I_B}$) des Gesamtstroms (I), wie nach der Änderung gemessen, in dem Fresnel-Diagramm sind,
und wobei $X_S$ und $Y_S$ zwei Unbekannte sind und jeweils die Abszisse und die Ordinate der Vektordarstellung der im Wesentlichen unveränderten Summe von einzelnen Strömen ($I_1$, $I_2$), in dem Fresnel-Diagramm, vor und nach der Änderung sind.

4. Verfahren nach einem der Ansprüche 1 bis 3, **dadurch gekennzeichnet, dass** Schritt b) Teilschritte umfasst, in denen:

- ein Intensitätswert AB mittels der folgenden Beziehung bestimmt wird:

$$AB = \sqrt{I_A^2 + I_B^2 - 2 \times I_A \times I_B \times \cos(\psi_B - \psi_A)}$$

wobei $I_A$ und $\psi_A$ jeweils eine gemessene Intensität und eine gemessene Phasenverschiebung des Gesamtstroms (I) vor der Änderung sind, und wobei $I_B$ und $\psi_B$ jeweils eine gemessene Intensität und eine gemessene Phasenverschiebung des Gesamtstroms (I) nach der Änderung sind,

- ein Winkelwert $\psi_1$ mittels der folgenden Beziehung bestimmt wird:

$$\psi_1 = \arcsin\left(\frac{I_B \times \cos\psi_B - I_A \times \cos\psi_A}{AB}\right),$$

- ein Winkelwert $\psi_2$ mittels der folgenden Beziehung bestimmt wird:

$$\psi_2 = \arccos\left(\frac{I_{3B}^2 + AB^2 - I_{3A}^2}{2 \times I_{3B} \times AB}\right)$$

wobei $I_{3A}$ und $I_{3B}$ jeweils eine Messung der Intensität des bestimmten einzelnen Stroms ($I_3$) vor der Änderung und eine Messung der Intensität des bestimmten einzelnen Stroms ($I_3$) nach der Änderung sind.

5. Verfahren nach Anspruch 4, **dadurch gekennzeichnet, dass** Schritt b) einen Teilschritt umfasst, in dem:

- die bestimmte einzelne Leistung nach der Änderung mittels der folgenden Beziehung bestimmt wird:

$$P_{3B} = U \times I_{3B} \times \sin\left(\psi_1 + \psi_2\right)$$

wobei $P_{3B}$ und U jeweils die bestimmte einzelne Leistung nach der Änderung und die Messung der Gesamtspannung (U) sind.

6. Verfahren nach einem der Ansprüche 4 und 5, **dadurch gekennzeichnet, dass** dieses einen Schritt umfasst, in dem:

- die Phasenverschiebung des bestimmten einzelnen Stroms ($I_3$) nach der Änderung mittels der folgenden Beziehung bestimmt wird:

$$\psi_{3B} = \pi/2 - \left(\psi_1 + \psi_2\right)$$

wobei $\psi_{3B}$ die Phasenverschiebung des bestimmten einzelnen Stroms ($I_3$) nach der Änderung ist.

7. Verfahren nach einem der vorhergehenden Ansprüche, **dadurch gekennzeichnet, dass**, in Schritt b), eine abweichende Lösung (S') unter zwei möglichen Lösungen (S, S') eliminiert wird.

8. Wechselstromanlage, umfassend eine Gruppe von mehreren Verzweigungen zur einzelnen Verteilung (4), die parallel geschaltet sind, sowie ein Überwachungssystem (6, 7, 9), das eingerichtet ist, Messungen einer Gesamtversorgungsspannung (U) der Gruppe von mehreren Verzweigungen (4) sowie Messungen von Intensitäts- und Phasenverschiebungswerten ($I_A$, $I_B$, $\psi_A$, $\psi_B$) eines Gesamtversorgungsstroms (I) der Gruppe von mehreren Verzweigungen (4) in der Zeit vorzunehmen und aufzuzeichnen, **dadurch gekennzeichnet, dass** das Überwachungssystem (6, 7, 9) eingerichtet ist, Messungen der Intensität ($I_{3A}$, $I_{3B}$) eines bestimmten einzelnen Stroms ($I_3$) in der Zeit vorzunehmen und aufzuzeichnen, der in einer bestimmten Verzweigung (4) unter den Verzweigungen der Gruppe zirkuliert, wobei das Überwachungssystem eine Rechnervorrichtung (9) umfasst, die in der Lage ist:

- eine Änderung aufgrund des elektrischen Verbrauchs in der bestimmten Verzweigung (4) zu detektieren, und
- unter Verwendung einer Messung der während der Änderung im Wesentlichen konstanten Gesamtspannung (U), von Messungen von Intensitäts- und Phasenverschiebungswerten ($I_A$, $I_B$, $\psi_A$, $\psi_B$) des Gesamtstroms (I) vor und nach der Änderung, sowie von Messungen der Intensitäten ($I_{3A}$, $I_{3B}$) des bestimmten einzelnen Stroms ($I_3$) vor und nach der Änderung, eine bestimmte einzelne Leistung zu bestimmen, die in der bestimmten Verzweigung (4) verbraucht wird,

wobei die Rechnervorrichtung (9) Mittel zur Durchführung eines Verfahrens nach einem der Ansprüche 1 bis 7 umfasst.

## Claims

1. Method for determining power consumption in an electrical installation (1), wherein a group comprising a plurality of parallel-connected individual distribution branches (4) is connected to an AC power supply (2), the method comprising the action of carrying out, over time, and recording measurements of the overall supply voltage (U) for the group comprising a plurality of branches (4), and measurements of the intensity and phase shift values ($I_A$, $I_B$, $\psi_A$, $\psi_B$) of the overall supply current (I) for the group comprising a plurality of branches (4), **characterized in that** the method comprises the action of carrying out, over time, and recording measurements of the intensity ($I_{3A}$, $I_{3B}$) of a specific individual current ($I_3$) flowing in a specific branch (4) among the branches of the group, the method including steps wherein:

   a) a change with regard to electricity consumption in the specific branch (4) is detected, and
   b) by using a measurement of the substantially constant overall voltage (U) during the change, measurements of the intensity and phase shift values ($I_A$, $I_B$, $\psi_A$, $\psi_B$) of the overall current (I) before and after the change, and measurements of the intensities ($I_{3A}$, $I_{3B}$) of the specific individual current ($I_3$) before and after the change, a specific individual power consumed in the specific branch (4) is determined,
   in said step b), the specific individual power is determined by deeming all ($I_1$, $I_2$) of the individual currents flowing in the branches (4) of the group, with the exception of the specific individual current ($I_3$), to add together to give a sum that is substantially unchanged at the end of the change in comparison with before the change, and two conditions to have to be simultaneously satisfied, which conditions are:

   - that the overall current (I) before the change must be substantially equal to the addition of the substantially unchanged sum to the specific individual current ($I_3$) before the change, and
   - that the overall current (I) after the change must be substantially equal to the addition of the substantially unchanged sum to the specific individual current ($I_3$) after the change,

   said step b) including sub-steps wherein:

   b1) by using measurements of the intensity and phase shift values ($I_A$, $I_B$, $\psi_A$, $\psi_B$) of the overall current (I) before and after the change, and measurements of the intensities ($I_{3A}$, $I_{3B}$) of the specific individual current ($I_3$) before and after the change, said substantially unchanged sum of individual currents ($I_1$, $I_2$) is determined,
   b2) that component that must be added to the substantially unchanged sum of individual currents ($I_1$, $I_2$) in order to obtain the overall current (I) is determined, this component being a determination of the specific individual current ($I_3$),
   b3) the specific individual power is calculated as being the product of the overall voltage and the specific individual current.

2. Method according to Claim 1, **characterized in that**, in sub-step b1), said substantially unchanged sum of individual currents ($I_1$, $I_2$) is determined as satisfying said two conditions simultaneously.

3. Method according to Claim 2, **characterized in that**, in sub-step b1), said substantially unchanged sum of individual currents ($I_1$, $I_2$) is determined by numerically solving a system of two equations having two unknowns, which is as follows:

$$\begin{cases} (X_A - X_S)^2 + (Y_A - Y_S)^2 = I_{3A}^2 \\ (X_B - X_S)^2 + (Y_B - Y_S)^2 = I_{3B}^2 \end{cases}$$

in which $I_{3A}^2$ and $I_{3B}^2$ are respectively a squared measurement of the intensity of the specific individual current

($I_3$) before the change and a squared measurement of the intensity of the specific individual current ($I_3$) after the change,

in which $X_A$ and $Y_A$ are respectively the abscissa and the ordinate of the vectorial representation ($\vec{I_A}$) of the overall current (I) as measured before the change, in a Fresnel diagram,

in which $X_B$ and $Y_B$ are respectively the abscissa and the ordinate of the vectorial representation ($\vec{I_B}$) of the overall current (I) as measured after the change, in the Fresnel diagram,

and in which $X_S$ and $Y_S$ are two unknowns and are repectively the abscissa and the ordinate of the vectorial representation of said substantially unchanged sum of individual currents ($I_1$, $I_2$), in the Fresnel diagram, before and after the change.

4. Method according to any one of Claims 1 to 3, **characterized in that** step b) comprises sub-steps wherein:

- an intensity value AB is determined by means of the following relationship:

$$AB = \sqrt{I_A^2 + I_B^2 - 2 \times I_A \times I_B \times \cos(\psi_B - \psi_A)}$$

in which $I_A$ and $\psi_A$ are respectively a measured intensity and phase shift of the overall current (I) before the change, and in which $I_B$ and $\psi_B$ are respectively a measured intensity and phase shift of the overall current (I) after the change,

- an angle $\psi_1$ is determined by means of the following relationship:

$$\psi_1 = \arcsin\left(\frac{I_B \times \cos\psi_B - I_A \times \cos\psi_A}{AB}\right),$$

- an angle $\psi_2$ is determined by means of the following relationship:

$$\psi_2 = \arccos\left(\frac{I_{3B}^2 + AB^2 - I_{3A}^2}{2 \times I_{3B} \times AB}\right)$$

in which $I_{3A}$ and $I_{3B}$ are respectively a measurement of the intensity of the specific individual current ($I_3$) before the change and a measurement of the intensity of the specific individual current ($I_3$) after the change.

5. Method according to Claim 4, **characterized in that** step b) comprises a sub-step wherein:

- the specific individual power after the change is determined by means of the following relationship:

$$P_{3B} = U \times I_{3B} \times \sin(\psi_1 + \psi_2)$$

in which $P_{3B}$ and U are respectively said specific individual power after the change and the measurement of the overall voltage (U).

6. Method according to either one of Claims 4 and 5, **characterized in that** it comprises a step wherein:

- the phase shift of the specific individual current ($I_3$) after the change is determined by means of the following relationship:

$$\psi_{3B} = \pi/2 - (\psi_1 + \psi_2)$$

in which $\psi_{3B}$ is the phase shift of the specific individual current ($I_3$) after the change.

7. Method according to any one of the preceding claims, **characterized in that**, in step b), an erroneous solution (S')
   is eliminated from two possible solutions (S, S').

8. AC electrical installation, having a group comprising a plurality of parallel-connected individual distribution branches
   (4), and a monitoring system (6, 7, 9) designed to carry out, over time, and record measurements of an overall
   supply voltage (U) for the group comprising a plurality of branches (4), and measurements of the intensity and phase
   shift values ($I_A$, $I_B$, $\psi_A$, $\psi_B$) of an overall supply current (I) for the group comprising a plurality of branches (4),
   **characterized in that** the monitoring system (6, 7, 9) is designed to carry out, over time, and record measurements
   of the intensity ($I_{3A}$, $I_{3B}$) of a specific individual current ($I_3$) flowing in a specific branch (4) among the branches of
   the group, the monitoring system having a calculating device (9) able:

   - to detect a change with regard to electricity consumption in the specific branch (4), and
   - by using a measurement of the substantially constant overall voltage (U) during the change, measurements
   of the intensity and phase shift values ($I_A$, $I_B$, $\psi_A$, $\psi_B$) of the overall current (I) before and after the change, and
   measurements of the intensities ($I_{3A}$, $I_{3B}$) of the specific individual current ($I_3$) before and after the change, to
   determine a specific individual power consumed in the specific branch (4),

   said calculating device (9) comprising means for carrying out a method according to any one of Claims 1 to 7.

Fig. 1

Fig. 2

**Fig. 3**

**Fig. 4**

**Fig. 5**

**Fig. 6**

**EP 2 795 348 B1**

## RÉFÉRENCES CITÉES DANS LA DESCRIPTION

### Documents brevets cités dans la description

- EP 2026299 A
- WO 2011002725 A